# EUROPÄISCHE PATENTSCHRIFT

(11) **EP 1 088 121 B1**
(45) Veröffentlichungstag und Bekanntmachung des Hinweises auf die Patenterteilung: **20.02.2002**
(21) Anmeldenummer: 99952103.2
(22) Anmeldetag: 14.05.1999
(51) Int. Cl.: C25D 1/00

(54) **VERFAHREN ZUR METALLISCHEN BESCHICHTUNG VON SUBSTRATEN**
METHOD FOR METAL COATING OF SUBSTRATES
PROCEDE POUR METALLISER DES SUBSTRATS

(30) Priorität: 16.05.1998 DE 19822075
(43) Veröffentlichungstag der Anmeldung: 04.04.2001
(73) Patentinhaber: Blasberg Oberflächentechnik GmbH, 42699 Solingen (DE)
(72) Erfinder: HUPE, Jürgen, D-40764 Langenfeld (DE); FIX, Sabine, D-42489 Wülfrath (DE); STEINIUS, Ortrud, D-42279 Wuppertal (DE)
(74) Vertreter: Werner, Hans-Karsten, Dr.Dipl.-Chem.
(86) Internationale Anmeldenummer: EP9903322
(87) Internationale Veröffentlichungsnummer: WO9960189

(56) Entgegenhaltungen:
- DE-A- 19 502 988
- J. HUPE : "DMS-E-Bekanntes Princip mit neuer Basis Durchkontaktierung von Leiterplatten auf Basis leitender Polymere" GALVANOTECHNIK, Bd. 86, Nr. 10, 1995, Seiten 3404-3411, XP002128202

## Beschreibung

Die Erfindung betrifft ein Verfahren zur metallischen Beschichtung von Substraten mit Polymeroberflächen bei der Herstellung von Leiterplatten, insbesondere von Leiterplatten mit Mikrobohrungen und Feinstrukturen, durch Auftragen einer elektrisch leitenden Polymerschicht und anschließende Metallisierung, wobei die elektrisch leitende Polymerschicht vor dem Metallisierungsschritt vorzugsweise mit einer zinnhaltigen, kolloidalen Palladiumlösung dotiert wird. Leiterplatten mit Mikrobohrungen und Feinststrukturen werden insbesondere in der sogenannten Build Up-Technologie erzeugt. Dabei werden im allgemeinen fertig erstellte doppelseitige Schaltungen als Kern verwendet und mit Polymeren beschichtet, in denen nach dem Stand der Technik z.B. photolithografisch oder mittels Laser Mikrobohrungen erzeugt werden, die als sogenannte Sacklochbohrungen (blind vias) bis zur nächsten leitenden Ebene führen.

Anschließend erfolgt nach dem in der DE-A-195 02 988 beschriebenen Stand der Technik eine Oberflächenstrukturierung des Polymers, eine Pd-Bekeimung sowie eine flächige Metallisierung der gesamten Schaltung mittels außenstromloser Kupferabscheidung. Die "Chemische" Kupferschicht wird gegebenenfalls elektrolytisch verstärkt.

In weiteren Arbeitsschritten erfolgt die Erzeugung des Leiterbildes mit entsprechenden Leiterzügen. Durch mehrfache Wiederholung dieser Vorgehensweise können Multilayer mit höherer Lagenzahl erzeugt werden. Daher spricht man von Sequential Build Up.

Aus der DE 38 06 884 ist ein Verfahren zur Durchkontaktierung von Leiterplatten (also der Metallisierung der Bohriochwandungen) auf Basis intrinsich leitender Polymere bekannt. Das Substrat wird in einer oxidierend wirkenden Lösung vorbehandelt, gespült und anschließend in eine wäßrige Monomerlösung von Pyrrol, Furan, Thiophen und/oder deren Derivaten getaucht und eine Nachbehandlung in sauren Lösungen vorgenommen. Dabei bildet sich selektiv auf elektrisch nicht leitenden Flächen (Polymer, Glas usw.) ein intrinisch leitender Polymerfilm, der anschließend galvanisch metallisiert wird.

Bei der Metallisierung der Bohrlochwandungen sind dabei Strecken zu überbrücken, die der Dicke der Leiterplatten entsprechen. Im allgemeinen werden dabei selten Strecken > 4 mm zu metallisieren sein. Die Leitfähigkeit der intrinisch leitenden Polymere reicht im allgemeinen aus, die Metallisierung innerhalb von einigen Minuten zu vollenden. Das laterale Kupferwachstum auf solchen Polymeren schwankt, je nach Polymertyp, zwischen 0,1 und 2,5 mm/min. Unter Annahme solcher Wachstumswerte ist eine flächige Metallisierung kompletter Leiterplatten mit bis zu 0,2 m² Fläche - und gegebenenfalls auch mehr - nicht oder nur nach sehr langer Zeit mit einer äußerst schlechten Schichtdikkenverteilung zu erreichen. Solche Leiterplatten entsprechen in keiner Weise den technischen Anforderungen. Daher ist es nötig, die Leitfähigkeit solcher intrinsisch leitender. Polymere deutlich zu erhöhen und das laterale Metallwachstum auf diesen Polymerfilmen beträchtlich zu steigern.

In der DE 195 02 988 wird ein Verfahren beschrieben, das die oben aufgezeigten Probleme lösen soll. Nach dem in DE 38 06 884 beschriebenen Verfahren wird zunächst das Substratpolymer mit einem elektrisch leitenden Polymer überzogen. Vor der galvanischen Metallisierung erfolgt jedoch eine Behandlung in einer wäßrigen metallionenhaltigen Lösung, vorzugsweise einer zinnhaltigen, kolloidalen Palladiumlösung. Dabei wird das intrinsisch leitende Polymer zusätzlich dotiert. Auf diese Weise sind verbesserte Leitfähigkeitswerte, sowie vor allem ein gesteigertes laterales Wachstum erreichbar. Im Falle von z.B. Poly-3,4ethylendioxythiophen können Metallwachstumswerte von bis zu 5 mm/min realisiert werden. Allerdings sind auch diese Werte für eine flächige Metallisierung noch nicht zufriedenstellend. Die Haftung des leitenden Polymers auf dem Polymer des Substrats ist mangelhaft. Es ist nämlich notwendig den leitenden Polymerfilm in der Form zu erzeugen, daß er fest auf dem Substratpolymer haftet. Dabei sind Haftfestigkeitswerte von mindestens 5 N/cm, eher jedoch 10 N/cm, notwendig.

Die Erfindung hat sich somit die Aufgaben gestellt, zunächst für eine ausreichende Haftung des leitenden Polymerfilms auf dem Polymersubstrat zu sorgen und vor allem das laterale Kupferwachstum noch weiter zu steigern.

Diese Aufgaben werden bei dem eingangs genannten Verfahren dadurch gelöst, daß das elektrisch leitende Polymere Poly-3,4-ethylen-dioxythiophen ist und vor der Metallisierung mit einer Kupfer(II)salzlösung in Kontakt gebracht wird. Vorzugsweise werden die Oberflächen der Substrate vor dem Auftrag der elektrisch leitenden Polymerschicht mindestens einmal folgenden Schritten unterworfen:
a) Quellen mittels wäßriger Laugen, organischer Lösungsmittel oder alkalischer Lösungsmittel,
b) Behandeln mit alkalischer Permanganatlösung und
c) Behandeln mit einem Reduktionsmittel.

Die Oberfläche des Substrats wird somit zunächst strukturiert. Dies geschieht in der Stufe a) durch Behandlung mit einem Quellermedium, einer Mischung geeigneter Lösungsmittel sowie durch Natron- oder Kalilauge. Die so vorbehandelte Substratpolymeroberfläche wird anschließend in einer alkalischen Permanganatlösung weiterstrukturiert. Dabei sollen möglichst viele und möglichst gleichmäßig über die gesamte Fläche verteilte Höhlungen von einigen wenigen µm-Durchmesser oder auch weniger entstehen, die die Haftung des leitfähigen Polymers verbessern. Solche Queller und alkalische Permanganatlösungen sind beispielsweise aus dem sogenannten Desmear-Prozeß von Multilayern bekannt. Unbekannt war, daß durch diese Schritte die Haftfestigkeit der leitfähigen Polymerschicht erheblich verbessert werden kann.

Je nach Substratpolymer ist es vorteilhaft, den Prozeß aus Quellen und Permanganatbehandlung mehrfach zu durchlaufen, um eine entsprechende Oberflächenstrukturierung zu bekommen. Der letzte Schritt des Verfahrens ist in jedem Fall ein Reduktionsprozeß in dem die Rückstände aus der Permanganatbehandlung, nämlich Braunstein, reduziert werden und somit die Oberfläche wieder rückstandsfrei gemacht wird. Als Reduktionsmittel hat sich H₂O₂ besonders bewährt.

Zur Durchführung des erfindungsgemäßen Verfahrens wird das Quellen des Substratpolymers durchgeführt mit einem Lösungsmittel bzw. einem Lösungsmittelgemisch dem gegebenenfalls und sogar bevorzugt ein Alkalihydroxid zugegeben wird. Es folgt dann die Behandlung mit alkalischer Permanganatlösung. Schließlich erfolgt der zuvor beschriebene Reduktionsschritt. Diese Maßnahmen führen zu einer gleichmäßigen Aufrauhung und Strukturierung des Substratpolymers und gewährleisten eine gute Haftung der nun aufzubringenden leitenden Polymerschicht.

Es hat sich gezeigt, daß besonders gute Haftfestigkeitswerte zu erzielen sind, wenn die Polymersubstrate vor der chemischen Behandlung einer mechanischen Vorbehandlung unterworfen werden. Hierzu eignen sich Bürsten, Sandstrahlen oder auch bevorzugt eine Behandlung mit Bimsmehl, als "Bimsbürsten" oder "Bimsstrahlen" bekannt. Auf diesem Wege kann die Haftfestigkeit nochmals um ca. 30 bis 40% gesteigert werden.

Die Bildung der leitfähigen Polymerschicht erfolgt prinzipiell in der Form wie sie in der DE 38 06 884 beschrieben ist.

Die erfindungsgemäß vorbehandelte und damit strukturierte Oberfläche wird zunächst in einem oxidierend wirkenden Bad, vorzugsweise einer Lösung von Kaliumpermanganat im pH-Bereich zwischen 1 und 14 - bevorzugt ca. 5 bis 8 - vorbehandelt. Zur Verbesserung der Haftung des zu bildenden Polymerfilms kann dem oxidierenden Schritt ein Tauchen in einem sogenannten Conditioner vorgeschaltet sein, wie es in der DE-A-42 05 190 beschrieben ist.

Anschließend wird gespült und das Substrat in eine monomere Lösung von 3,4-Ethylendioxythiophen gebracht. Anschließend wird das monomer-behaftete Substrat ohne zu spülen in eine saure Lösung gebracht, in der infolge einer oxidativen Polymerisation die Bildung des leitenden Polymerfilms erfolgt. Im Falle von Kaliumpermanganat als Oxidationsmedium bildet sich im ersten Schritt als Reaktionsprodukt von Substratpolymer und KMnO₄ eine Braunsteinschicht aus, die polymer-getränkt in der oben beschriebenen sauren Lösung als Oxidationsmittel wirkt.

Als Säuren werden vorzugsweise Schwefel-, Phosphor- oder Sulfonsäuren verwendet; besonders geeignet sind z.B. Polyphosphorsäuren oder polymere Sulfonsäuren. In einer besonders bevorzugten Version der Erfindung werden Polystyrolsulfonsäure oder deren Salze verwendet.

Der elektrische Widerstand der so gebildeten leitenden Polymerschicht beträgt im allgemeinen in Abhängigkeit der Arbeitsparameter sowie vor allem der verwendeten Säure bzw. der verwendeten Monomerverbindung ca. 5 bis 500 KΩ. Dabei wird der Widerstand durch die Bohrung einer Leiterplatte gemessen. Die Dicke der Platte beträgt bei dieser Messung d = 1,6 mm und der Bohrungsdurchmesser 1,0 mm.

Die niedrigsten Widerstandswerte werden bei Verwendung von 3,4-Ethylendioxythiophen sowie Polystyrolsulfonsäure erreicht.

Von entscheidender Bedeutung für die Metallisierung größerer Flächen ist das laterale Kupferwachstum. Bei Verwendung von 3,4-Ethylendioxythiophen und Polystyrolsulfonsäure werden optimale Werte von bis zu 3,0 mm/min erzielt. Dies ist jedoch für flächige Abscheidung noch nicht ausreichend. Nach dem erfindungsgemäßen Verfahren erfolgt daher zunächst eine Nachbehandlung zur Verbesserung des lateralen Kupferwachstums gemäß DE-A- 195 02 988, durch Dotierung mit einer zinnhaltigen, kolloidalen Palladiumlösung.

Das mit leitendem Polymer beschichtete Substrat wird dazu in eine derartige metallhaltige Lösung getaucht. Dabei handelt es sich um eine kolloidale Palladiumlösung, die als Kolloidstabilisator Zinn(II)salze verwendet. Solche Palladium "Katalysatoren" werden seit Jahren zur chemischen Metallisierung von Kunststoffsubstraten als Aktivatorlösungen benutzt. Die erfindungsgemäß eingesetzten Lösungen können aber höhere Palladiumkonzentrationen als üblich enthalten, nämlich anstelle von ca. 50 mg/l bis zu mehreren g/l.

Durch diese Nachbehandlung wird der leitende Polymerfilm mit dem Metall, nämlich Pd und Sn²⁺, beaufschlagt. Nach einem Spülprozeß wird die so beaufschlagte Platte in eine Kupfer(II) salzlösung getaucht, die gegebenenfalls Komplexbildner, Stabilisator und pH-Wert-Korrektoren enthält. Dabei erfolgt anscheinend im Ionenaustausch die Abscheidung von Kupfer auf dem leitenden Polymerfilm. Dies führt nicht nur zu einer Reduzierung des elektrischen Widerstands, sondern auch zu einer Steigerung des lateralen Kupferwachstums. Aufgrund der erfindungsgemäßen Kombination von leitendem Polymer, Metalldotierung und Kontaktieren mit einer Kupfer(II)salzlösung wird das laterale Kupferwachstum von 2,5 mm/min auf bis zu 40 mm/min und mehr gesteigert; dies ermöglicht die anschließende elektrolytische Metallisierung, z.B. Verkupferung, auch von größeren Flächen in ausreichend kurzer Zeit mit gleichmäßiger Metallverteilung über das flächige Substrat und gute Haftung.

Es wird vermutet, daß durch die zusätzliche Inkorporation von Metall, die Keimbildung während der Metallisierung deutlich schneller verläuft und somit ein schnelleres laterales Wachstum realisiert wird.

Die erfindungsgemäßen Verfahrensschritte erfolgen vorzugsweise wie folgt:

| | | | |
|---|---|---|---|
| 1. | Quellen | T: 40 bis 85°C | t: 0,5 bis 15 min |
| | | | |
| 2. | Spülen Alk. KMnO₄ | T: 60 bis 95°C | t: 1 bis 30 min |
| | | | |
| 3. | Spülen Reduktion | T: 20 bis 45°C | t: 0,2 bis 5 min |
| | | | |
| | Spülen | | |
| | | | |
| | Dieser Vorgang kann gegebenenfalls komplett oder auch nur partiell - gegebenenfalls auch mehrfach - wiederholt werden. | | |
| | | | |
| 4. | Conditioner | T: 20 bis 60°C | t: 0,1 bis 5 min |
| | | | |
| | Spülen | | |
| | | | |
| 5. | KMnO₄ (pH 1-14) | T:50 bis 95°C | t: 0,3 bis 10 min |
| 6. | Spülen | | |
| | | | |
| | Gegebenenfalls kann eine Spülsequenz benutzt werden, die mit Wasser, schwefelsaurer Lösung (pH 1 bis 5), Wasser, schwach alkalischer Lösung (pH 7 bis 9) und wiederum Wasser abläuft. | | |
| | | | |
| 7. | Monomer | T: 10 bis 40°C | t: 0,3 bis 7 min |
| | | | |
| 8. | Säure | T: 10 bis 40°C | t: 0,3 bis 10 min |
| | | | |
| 9. | Metalllösung I (zinnhaltige, Palladiumlösung) | T: 20 bis 70°C kolloidale | t: 0,2 bis 10 min |
| | | | |
| | Spüle | | |
| | | | |
| 10. | Metalllösung II (Kupfer(II)salzlösung) | T: 20 bis 80°C | t: 0,2 bis 10 min |
| | | | |
| | Spüle | | |
| | | | |
| 11. | gegebenenfalls Trocknen oder Tempern | | |
| | | | |
| 12. | Dekapieren (5 bis 10% Säure) | T: 20 bis 30°C | t: 0,1 bis 5 min |
| | | | |
| | gegebenenfalls Spülen | | |
| | | | |
| 13. | Elektrolytische Metallisierung | | |
| | | | |
| | Üblicherweise erfolgt die Metallisierung mit Stromdichten von ca. 0,5 bis 10 A/dm², je nach Anlagendesign (horizontal oder vertikal), über eine Zeitraum, der gewährleistet, daß die gewünschte Metallschicht abgeschieden wird. | | |
| | Spüle | | |
| | | | |
| 14. | Trocknen | | |
| | | | |
| 15. | Tempern | | |
| | | | |
| | Das so behandelte Polymersubstrat weist eine haftfeste, gleichmäßige Metallisierung von großen flächigen Gebilden (z.B. eine Leiterplatte der Abmessung 405x535 mm) auf. | | |

Die Schritte 7. und 8. können gegebenenfalls auch zu einer Stufe zusammengefaßt sein. Vorzugsweise wird horizontal gearbeitet.

Das Verfahren ist in den nachfolgenden Beispielen näher erläutert.

### Beispiele

Sämtliche Versuche wurden mit zwei verschiedenen Polymersubstraten durchgeführt, auf denen die Metallisierung erfolgt. Das erfindungsgemäße Verfahren ist jedoch nicht auf diese Polymersubstrate beschränkt.
- Polymer A:: Epoxypolymer (Standard FR-4 Basismaterial)
- Polymer B:: Epoxypolymer (Probelec® XB7081, Photodielektrikum) Probelec® ist ein eingetragenes Warenzeichen der Ciba Speciality Chemicals Inc.

Die Abmessungen der benutzten Substrate variierte je nach Versuchsziel. Zur Bestimmung des(r)

| | |
|---|---|
| lateralen Kupferwachstums | 35 x 100 mm |
| Haftfestigkeit | 35 x 100 mm |
| Metalldotierung | 0,5 dm² Fläche |

### I. Strukturierung der Polymersubstrate

Die Substratabschnitte wurden jeweils unter leichter Bewegung in dem nun beschriebenen Tauchprozeß behandelt. Auch die später folgenden Arbeitsschritte wurden in Tauchprozessen ausgeführt. Es sei aber ausdrücklich angemerkt, daß das erfindungsgemäße Verfahren mit gleichem Erfolg auch in Durchlaufanlagen, sei es vertikal oder horizontal, durchgeführt werden kann. Dies gilt auch für die galvanische Metallisierung. Im allgemeinen reduzieren sich in dem Falle die Prozeßzeiten in Abhängigkeit der Flutungsparameter deutlich.

Für den Produktionseinsatz ist die Anwendung des erfindungsgemäßen Verfahrens sogar bevorzugt in Durchlaufanlagen durchzuführen. Da das Verfahren im Grundprinzip unabhängig von Tauch- oder Durchlaufanlagenkonzepten ist, wird im folgenden nur von Tauchprozessen die Rede sein.

Die nachfolgend beschriebenen Arbeitsschritte, Konzentrationen, Temperaturen, Zeiten usw. und chemischen Komponenten schränken die Erfindung nicht ein, sondern sind lediglich bevorzugte Ausführungsformen.

| Vorbehandlung für Polymer A | | | |
|---|---|---|---|
| 1. | Quellen (Wäßrige Lösung von 330 ml/l N-Methylpyrrolidon und 12 g/l NaOH) | T: 55°C | t = 10 min |
| | | | |
| 2. | Spülen in Wasser min | T: RT | 2 x je 1 |
| | | | |
| 3. | Oxidation (Wäßrige Lösung von 65 g/l KMnO₄ und 40 g/l NaOH) | T: 80°C | t = 12 min |
| | | | |
| 4. | Spülen in Wasser min | T: RT | 3 x je 1 |
| | | | |
| 5. | Reduzieren (Wäßrige Lösung von 50 ml/l H₂O₂, 35% und 50 ml/l H₂SO₄) | T: RT | t = 1 min |
| | | | |
| | | | |
| 6. | Spülen in Wasser min | T: RT | 2 x je 1 |
| | | | |
| 7. | Trocknen | | |

| Vorbehandlung für Polymer B | | | |
|---|---|---|---|
| 1. | Quellen Enplate MLB 2010* (Lösungsmittelgemisch mit NaOH Zusatz) | T: 80°C | t = 1 min |
| | | | |
| 2. | Spülen in Wasser | T: RT | t = 5 min |
| | | | |
| 3. | Oxidation (Wäßrige Lösung von 60 g/l KMnO₄ und 45 g/l NaOH) | T: 80°C | t = 5 min |
| | | | |
| 4. | Spülen in Wasser | T: RT | t = 5 min |
| | | | |
| 5. | Reduktion wie unter Polymer A 5. beschrieben | | |
| | | | |
| 6. | Spülen in Wasser | | |

| | | | |
|---|---|---|---|
| * Ein Produkt der Enthone-OMI Inc. | | | |

In einer bevorzugten Ausführungsform werden die Schritte 3. bis 6. nochmals wiederholt, wobei die Zeit in Schritt 3. auf t = 8 min erhöht wird. Anschließend wird getrocknet.

Unter Umständen kann die Prozedur auch noch mehrfach wiederholt werden.

Nach dem Vorbehandlungsprozeß weisen die Polymersubstrate eine gleichmäßige Strukturierung mit einer Vielzahl von kleinen Oberflächenkavernen (∅ ca. 1 bis 3 µm) auf. Die so strukturierte Oberfläche bietet einen guten Haftgrund für das nun aufzubringende leitende Polymer.

### II. Beschichtung mit leitendem Polymer

Als leitfähige Polymerschicht wird Poly-3,4-ethylendioxythiopen (Poly-EDT) gewählt, da hiermit die besten Ergebnisse erzielt wurden.

Insgesamt wurden 4 verschiedene Arbeitsabläufe überprüft.

| Ablauf 1 | | | |
|---|---|---|---|
| 1. | Conditioner (gemäß DE-A-42 05 190) Blasolit V ** | T: 40°C | t = 1 min |
| | | | |
| 2. | Spülen in Wasser min | T: RT | 2 x je 1 |
| | | | |
| 3. | Oxidation (Wäßrige Lösung von 70 g/l KMnO₄. Der pH-Wert wird mit verdünnter Säure auf ca. 7 eingestellt). | T: 80°C | t = 2 min |
| | | | |
| 4. | Spülen in Wasser min | T: RT | 3 x je 1 |
| | | | |
| 5. | Monomerlösung DMSE, CAT V-10 ** (enthält ca. 1,5% EDT) | T: RT | t = 1 min |
| | | | |
| 6. | Säure | T: RT | t = 1 min |
| | | | |
| | 6.1 Wäßrige Lösung von 20 g/l Polystyrolsulfonsäure | | |
| | alternativ: | | |
| | | | |
| | 6.2 Wäßrige Lösung mit 150 g/l H₂SO₄ | | |
| | | | |
| 7. | Spülen in Wasser min | T: RT | 2 x je 1 |
| | | | |
| 8. | Trocknen | | |

| | | | |
|---|---|---|---|
| ** Ein Produkt der Blasberg Enthone-OMI, Deutschland | | | |

| Ablauf 2 | | | |
|---|---|---|---|
| Die Schritte 1 bis 4 entsprechen dem Ablauf 1. Jedoch wird der leitende Polymerfilm in einem Schritt erzeugt. | | | |
| | | | |
| 5. | Polymerisationslösung (Wäßrige Lösung von 0,12% EDT, 0,15% Emulgator (z.B. Arylpolyglykolether) und 0,4% Polystyrolsulfonsäure | T: RT | t = 3 min |
| | | | |
| 6. | Spülen in Wasser | | |
| | | | |
| 7. | Trocknen | | |

| Ablauf 3 | | | |
|---|---|---|---|
| 1. | Lösungsmittel-Conditioner Condisolve HP ** (gemäß DE-A-42 05 190) | T: 55°C | t = 8 min |
| | | | |
| 2. | Spülen in Wasser min | T: RT | 2 x je 1 |
| | | | |
| 3. | Oxidation (Wäßrige Lösung von 60 g/l KMnO₄ und 40 g/l NaOH. Der K₂MnO₄-Gehalt wird bei ca. 10 bis 20 g/l gehalten). | T: 75°C | t = 3 min |
| | | | |
| 4. | Spülen in Wasser min | T: RT | 3 x je 1 |
| | | | |
| 5. | Polymerisationslösung | T: RT | t = 3 min |
| | | | |
| | 5.1 Polymerisationslösung wie in Ablauf 2 beschrieben | | |
| | | | |
| | 5.2 Wäßrige Lösung von 0,3% EDT, 0,4% Emulgator und 6 g/l | | |
| | | | |
| | Polyphosphorsäure (84%ig) | | |
| | | | |
| 6. | Spülen in Wasser | | |
| | | | |
| 7. | Trocknen | | |

| Ablauf 4 | | | |
|---|---|---|---|
| 1. | Lösungsmittel-Conditioner Condisolve HP ** | T: 55°C | t = 8 min |
| | | | |
| 2. min | Spülen in Wasser | T: RT | 2 x je 1 |
| | | | |
| 3. | Oxidation (siehe Ablauf 3, 3.) Weitere Abfolge wie unter Ablauf 3 beschrieben. | T: 80°C | t = 10 min |

### III. Nachbehandlung der leitenden Polymerschicht mit metallhaltigen Lösungen

| Variante 1 (entspricht DE 195 02 988) | | | |
|---|---|---|---|
| 1. | HCl 8%ige wäßrige Lösung | T: RT | t = 2 min |
| | | | |
| 2. | Metallhaltige Lösung I Kolloidale Pd-Lösung mit 1 g/l Palladium 20 g/l Zinn(II)chlorid und 8% HCl | T: RT | t = 5 min |
| | | | |
| 3. | HCl, 8%ige wäßrige Lösung | T: RT | t = 2 min |
| | | | |
| 4. | Spülen in Wasser | | |
| | | | |
| 5. | Trocknen | | |

| Variante 2 | | | |
|---|---|---|---|
| 1. | Metallhaltige Lösung I ABC 888 M *** (kolloidale Pd-Lösung mit ca. 300 mg/l Pd Kolloidstabilisator: Zinn(II)chlorid) | T: 45°C | t = 4 min |
| | | | |
| 2. | Spülen in Wasser min | T: RT | 2 x je 1 |
| | | | |
| 3. | Beschleunigen ABC 580 S *** | T: 45°C | t = 1 min |
| | | | |
| 4. | Spülen in Wasser min | T: RT | 2 x je 1 |
| | | | |
| 5. | Trocknen | | |

| Variante 3 | | | |
|---|---|---|---|
| 1. | Metallhaltige Lösung I ABC 888 M *** (s.o.) | T: RT | t = 4 min |
| | | | |
| 2. | Spülen | | |
| | | | |
| 3. | Metallhaltige Lösung II | T: 63°C | t = 5 min |
| | (Wäßrige Lösung von 5 g/l CuSO₄ x 5H₂O, | | |
| | 50 g/l Na₂CO₃, | | |
| | 50 g/l NaOH | | |
| | 30 g/l Kaliumnatrium-tartrat) | | |
| | | | |
| 4. | Spülen in Wasser min | T: RT | 2 x je 1 |
| | | | |
| 5. | Trocknen | | |

| | | | |
|---|---|---|---|
| *** Ein Produkt der APT, Advanced Plating Technologies, Israel | | | |

Die beschriebenen Konzentrationen, Zeiten, Temperaturen und auch chemischen Komponenten beschränken den Umfang des erfindungsgemäßen Verfahrens nicht, sondern stellen nur bevorzugte Ausführungen des Verfahrens dar.

### IV. Metallisierung der erfindungsgemäß behandelten Polymersubstrate

Da die Verkupferung von solchen Substraten herausragende Bedeutung besitzt, wird im folgenden nur die elektrolytische Verkupferung als Metallisierungsprozeß beschrieben.

Als Verkupferungselektrolyte können alle handelsüblichen Kupferverfahren eingesetzt werden. Als besonders geeignet hat sich ein Mattkupferelektrolyt CUPROSTAR LP-1 ** erwiesen, daher wird beispielhaft auf diesen Elektrolyten Bezug genommen.

Die Substrate werden zunächst in einer wäßrigen schwefelsauren Lösung (ca. 5 bis 10 Vol.%) für 30 bis 60 s dekapiert und so dann im Kupferelektrolyten CUPROSTAR LP-1 verkupfert.

| Elektrolytzusammensetzung: | |
|---|---|
| Kupfer | 20 g/l |
| H₂SO₄ | 200 g/l |
| NaCl | 100 mg/l |
| Zusatzmittel LP-1 ** | 4 ml/l |
| Stromdichte: | 2 A/dm² |

Die Verkupferungszeit war je nach Beispiel unterschiedlich.

Die Ergebnisse waren unabhängig davon, ob eine normale Gleichstromabscheidung oder aber mit Pulse-Reverse-Abscheidung gearbeitet wurde. Im letzten Falle wurde ein Pulseregime von 100 mS kathodisch, sowie 1 mS anodisch eingestellt, wobei die anodische Stromdichte im allgemeinen höher (Faktor 2 bis 3 zu 1 ) gewählt war.

Die Ergebnisse und Bedingungen der einzelnen Beispiele sind der folgenden Tabelle zu entnehmen (Beispiele 1 bis 26). Es ist deutlich erkennbar, daß durch die Dotierung mit Metallionen, insbesondere mit zinnhaltigen, kolloidalen Palladiumlösungen, ein deutlich gesteigertes laterales Wachstum zu erzielen ist. Mit diesen Werten ist es möglich, auch größere Flächen in kürzerer Zeit zu metallisieren.

Die durch die erfindungsgemäße Vorbehandlung zu erzielende Haftfestigkeitswerte sind ebenfalls akzeptabel.

### Beispiele 27/28

Die Versuchsabfolge von Beispiel 22 und 25 wird wiederholt in dem der chemischen Strukturierung eine Bimsmehlbehandlung vorgeschaltet wird.

| | |
|---|---|
| Durchlaufgeschwindigkeit | 3,5 m/min |
| Verweilzeit | ca. 15 s |
| Material | 2/ON |
| | (Produkt der Firma Vogel und Prenner) |

Unter diesen Bedingungen werden Haftfestigkeitswerte von ca. 10 N/cm erreicht.

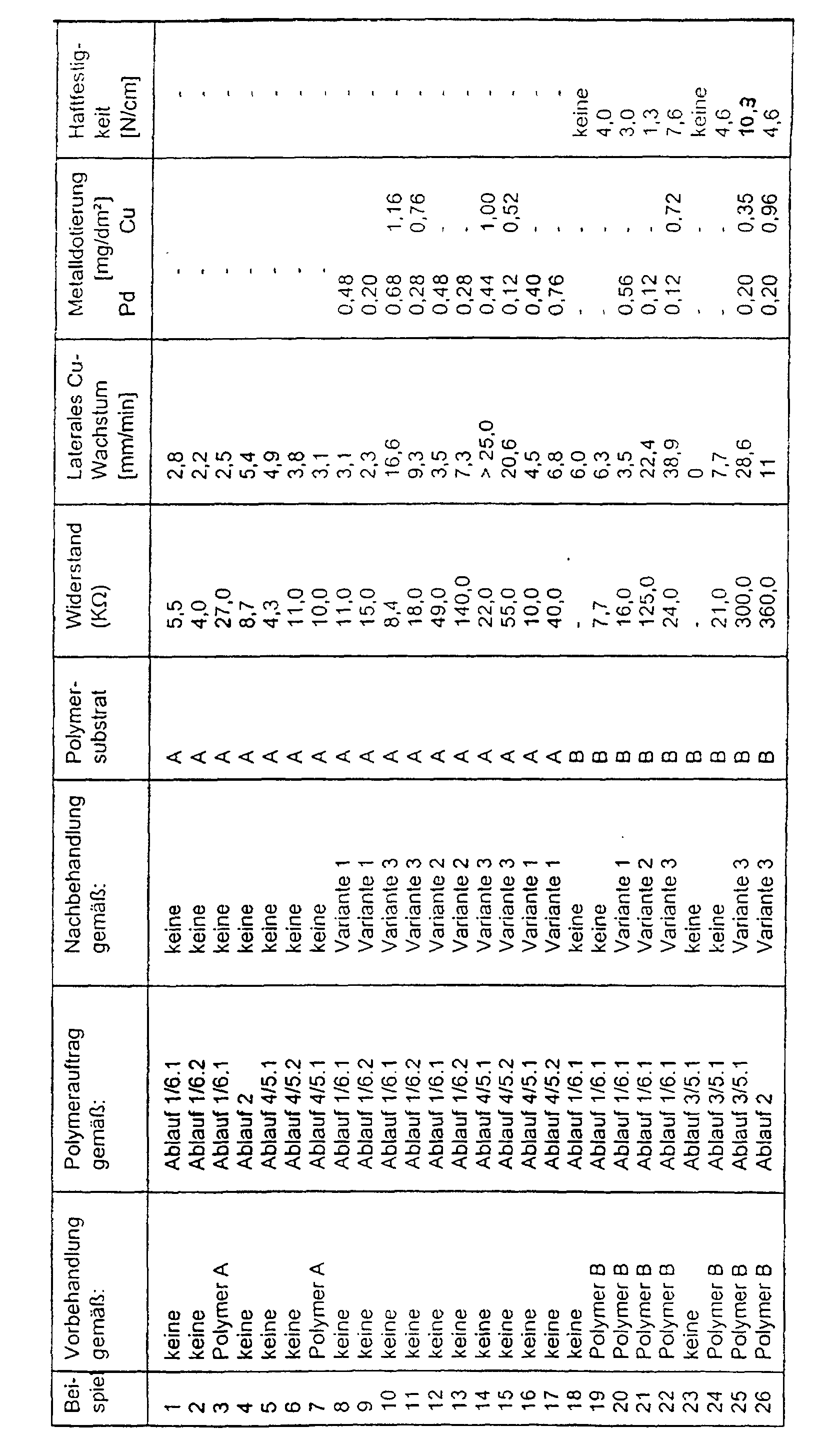

Die Messung der Abzugskraft erfolgte gemäß DIN 53 494.

| | |
|---|---|
| Substrat | 3,5 x 10 cm |
| Schichtdicke | 40 µm ± 4 µm |
| Probestreifen | 10 mm breit, wurde über eine Strecke von 50 mm gezogen. |
| Abzugsgeschwindigkeit | 75 mm/min |

## Patentansprüche

1. Verfahren zur metallischen Beschichtung von Substraten mit Polymeroberflächen bei der Herstellung von Leiterplatten, insbesondere von Leiterplatten mit Mikrobohrungen und Feinstrukturen, durch Auftragen einer elektrisch leitenden Polymerschicht und anschließende Metallisierung, wobei die elektrisch leitende Polymerschicht vor dem Metallisierungsschritt mit einer zinnhaltigen, kolloidalen Palladiumlösung dotiert wird, **dadurch gekennzeichnet, daß** das elektrisch leitende Polymere Poly-3,4-ethylen-dioxythiophen ist und vor der Metallisierung mit einer Kupfer(II)salzlösung in Kontakt gebracht wird.

2. Verfahren gemäß Anspruch 1, **dadurch gekennzeichnet, daß** die Oberflächen der Substrate vor dem Auftrag der elektrisch leitenden Polymerschicht mindestens einmal folgenden Schritten unterworfen werden:
a) Quellen mittels wäßriger Laugen, organischer Lösungsmittel oder alkalischer Lösungsmittel,
b) Behandeln mit alkalischer Permanganatlösung und
c) Behandeln mit einem Reduktionsmittel.

3. Verfahren gemäß Anspruch 1 oder 2, **dadurch gekennzeichnet, daß** die Oberflächen der Substrate vor dem Schritt a) mechanisch aufgerauht werden durch Bürsten, Sandstrahlen, Bimsbürsten oder Bimstrahlen.

4. Verfahren gemäß einem der Ansprüche 1 bis 3, **dadurch gekennzeichnet, daß** das Verfahren horizontal durchgeführt wird.

## Claims

1. A process for the metal coating of substrates having polymer surfaces in the preparation of circuit boards, especially of circuit boards having microbores and fine structures, by applying an electrically conductive polymer layer followed by metal coating, wherein said electrically conductive polymer layer is doped with a tin-containing colloidal palladium solution prior to the metal-coating step, **characterized in that** the electrically conductive polymer is poly-3,4-ethylenedioxythiophene, which is contacted with a copper(II) salt solution prior to the metal coating.

2. The process according to claim 1, **characterized in that** the surfaces of the substrates are subjected to the following steps at least once prior to the application of said electrically conductive polymer layer:
a) swelling by means of aqueous lyes, organic solvents or alkaline solvents;
b) treating with alkaline permanganate solution; and
c) treating with a reductant.

3. The process according to claim 1 or 2, **characterized in that** the surfaces of the substrates are mechanically roughened by brushing, sandblasting, pumice-brushing or pumice-blasting prior to step a).

4. The process according to any of claims 1 to 3, **characterized in that** the process is carried out in a horizontal way.

## Revendications

1. Procédé pour le revêtement métallique de substrats ayant des surfaces polymères lors de la fabrication de cartes imprimées, en particulier de cartes imprimées comportant des microtrous et des structures fines, par application d'une couche polymère conductrice de l'électricité, suivie d'une métallisation, la couche polymère conductrice de l'électricité étant, avant l'étape de métallisation, dopée par une solution colloïdale de palladium contenant de l'étain, **caractérisé en ce que** le polymère conducteur de l'électricité est le poly(3,4-éthylène-dioxythiophène) et est mis en contact avant la métallisation avec une solution d'un sel de cuivre(II).

2. Procédé selon la revendication 1, **caractérisé en ce que** les surfaces des substrats sont, avant application de la couche polymère conductrice de l'électricité, au moins soumises une fois aux étapes suivantes :
a) gonflement à l'aide de bases aqueuses, de solvants organiques ou de solvants alcalins,
b) traitement par une solution alcaline de permanganate, et
c) traitement par un agent réducteur.

3. Procédé selon la revendication 1 ou 2, **caractérisé en ce que** les surfaces des substrats sont rendues mécaniquement rugueuses avant l'étape a), par brossage, sablage, ponçage à la brosse ou au jet.

4. Procédé selon l'une des revendications 1 à 3, **caractérisé en ce que** le procédé est mis en oeuvre d'une manière horizontale.
